# DEMANDE DE BREVET EUROPEEN

(11) **EP 2 141 811 A1**
(43) Date de publication de la demande: **06.01.2010**
(21) Numéro de dépôt: 09164577.0
(22) Date de dépôt: 03.07.2009
(51) Int. Cl.: H03K 17/96, H03K 17/955

(54) **Procédé de sélection d'un équipement et organe de commande permettant de mettre en oeuvre ce procédé**

(30) Priorité: 03.07.2008 FR 0854535
(71) Demandeur: Somfy SAS, 74300 Cluses (FR)
(72) Inventeur: Duchene, Isabelle, 74970, MARIGNIER (FR); Mathieu, Jérôme, 74130, BONNEVILLE (FR)
(74) Mandataire: Myon, Gérard Jean-Pierre

(57) **Abrégé**

On sélectionne un groupe d'équipements domotiques (111-114) à commander parmi plusieurs groupes d'équipements prédéfinis, au moyen de zones sensitives (Z1, Z2, Z3, Z4) d'un organe de commande (102), ces zones sensitives étant chacune associées à un capteur capacitif et étant disposées côte à côte au niveau de l'organe de commande. On sélectionne un groupe d'équipements prédéfini associé à une zone sensitive donnée (Z1, Z2, Z3, Z4) en activant le capteur capacitif de cette zone sensitive. On sélectionne au moins un groupe supplémentaire d'équipements différent de ceux correspondant à chaque zone sensitive, au moyen d'une séquence prédéterminée (Z1-Z2-Z3-Z4) d'activations de plusieurs capteurs capacitifs, dont au moins deux capteurs capacitifs correspondant à deux zones sensitives (Z1-Z2-Z3-Z4) non adjacentes.

## Description

L'invention relève du domaine des interrupteurs de commande destinés à la commande d'appareils domotiques, et en particulier des fonctions proposées au niveau de ces interrupteurs. De tels interrupteurs permettent en effet à un utilisateur de sélectionner une commande à adresser à un ou plusieurs appareils électriques. Ils comprennent une interface, dite interface homme-machine, au travers de laquelle les commandes souhaitées par un utilisateur sont traduites en un ordre de commande destiné aux appareils. Ces ordres de commande sont en particulier transmis par voie filaire, par exemple par bus, câble, courant porteur, etc, ou par voie non filaire, par exemple par radio, infrarouge, etc.

Quel que soit le mode de transmission, il est courant que de tels interrupteurs proposent un nombre important de fonctions malgré un nombre réduit de touches. La télécommande Telis 4, commercialisée par la demanderesse et destinée à la commande de volets roulants ou d'écrans de protection solaire motorisés, propose ainsi, outre les fonctions associées aux boutons de commande relatives à la montée, à la descente (ou ouverture-fermeture) et à l'arrêt, un bouton commun de sélection d'un canal de commande, combiné à l'utilisation de 4 diodes électroluminescentes. Les ordres émis à partir d'une télécommande Telis 4 sont émis par radio vers un appareil ou un groupe d'appareils sélectionné par activation d'un canal radio. Ainsi, un premier appareil peut être commandé individuellement au travers du canal 1, un deuxième appareil au travers du canal 2, un troisième appareil au travers du canal 3 et un quatrième appareil au travers du canal 4. Un cinquième canal est disponible à la suite du canal 4, le canal 5 pouvant permettre de commander les quatre appareils en groupe.

La configuration de l'association entre un canal et un ou plusieurs appareils est réalisée le plus souvent par un installateur. Par contre, à l'usage, l'utilisateur sélectionne le canal choisi grâce à un ou plusieurs appuis sur le bouton commun de sélection, puis donne l'ordre par un des boutons de commande. Le canal 1 est le canal sélectionné par défaut. Les autres canaux sont sélectionnés cycliquement en renouvelant les appuis sur le bouton de sélection. Quatre diodes électroluminescentes (LEDs) permettent à l'utilisateur de visualiser lequel des canaux 1 à 4 est le canal actif. Chacun de ces canaux est repéré par l'allumage de la diode correspondante. Le cinquième canal est repéré par l'allumage simultané des quatre diodes LED1, LED2, LED3, LED4 relatives aux quatre premiers canaux. Bien que cette ergonomie soit satisfaisante, elle nécessite des appuis multiples et peut obliger parfois l'utilisateur à refaire le cycle d'appui quasi au complet pour un simple changement de canal. D'autre part, elle devient également fastidieuse lorsque le nombre de canaux augmente.

La demande de brevet DE-A-101 10 759 divulgue l'utilisation de capteurs capacitifs pour la fabrication d'un interrupteur multiple pouvant servir à la commande de plusieurs équipements électriques. Chaque équipement est commandé par activation du capteur capacitif qui lui est dédié.

La demande de brevet FR 2 811 162 décrit un dispositif qui permet de délivrer un signal de commande caractéristique d'une zone effleurée ou une succession de signaux définissant le sens de l'effleurement afin de discriminer une commande de montée d'une commande de descente.

La demande de brevet US-A-2006/0256089 décrit par ailleurs une interface utilisateur basée sur la technologie capacitive. Cette technologie est couramment employée dans les panneaux de commande d'appareils électroménagers, pour des écrans de lecteurs de musique portatifs, sur les écrans d'appareils médicaux. Elle permet de repérer le positionnement ou les mouvements de translation d'un doigt sur la surface d'écran. Ces actions sont ensuite traduites par un microcontrôleur en des signaux de sortie vers les appareils électriques.

En particulier, ce document vise à réduire le nombre de capteurs sans pour autant réduire le nombre de signaux de sortie possibles. Le panneau de commande prévoit donc un ensemble de capteurs répartis sur le panneau et des moyens de détections dont le fonctionnement est le suivant : lorsqu'un seul capteur d'une paire de capteurs adjacents est activé, un premier signal de sortie est fourni tandis que, si les deux capteurs d'une paire de capteurs sont activés, un deuxième signal de sortie est fourni, ce deuxième signal correspondant à un deuxième état de sortie. Ce document précise que l'activation des capteurs peut inclure une action de glissement sur la surface du panneau. Cependant, l'activation de capteurs adjacents peut être le fait d'une action involontaire de la part de l'utilisateur, ce phénomène étant accentué lorsque le nombre de capteurs augmente par rapport à la surface du panneau. Il apparaît donc que des sélections involontaires peuvent être réalisées.

L'invention se propose de remédier aux problèmes précédemment évoqués. En particulier, l'invention se propose d'utiliser les propriétés précédemment décrites de la technologie capacitive, mais de manière à proposer des fonctions dont l'activation est sûre et garantie.

A cet effet, l'invention concerne un procédé de sélection d'un groupe d'équipements domotiques à commander parmi plusieurs groupes d'équipements prédéfinis, au moyen de zones sensitives d'un organe de commande, ces zones sensitives correspondant chacune à un capteur capacitif et étant disposées côte à côte au niveau de l'organe de commande, le procédé de sélection étant tel que :
- on sélectionne un groupe d'équipements prédéfini associé à une zone sensitive donnée en activant le capteur capacitif correspondant à cette zone sensitive ; et
- on sélectionne au moins un groupe supplémentaire d'équipements, différent de ceux correspondant à chaque zone sensitive, au moyen d'une séquence prédéterminée d'activations de plusieurs capteurs capacitifs, dont au moins deux capteurs capacitifs correspondant à deux zones sensitives non adjacentes.

Grâce à l'invention, il est possible de commander facilement des groupes d'équipements en nombre relativement élevé, tout en utilisant un organe de commande simple, économique et peu volumineux. Au sens de l'invention, un groupe d'équipements peut ne comprendre qu'un seul équipement, par exemple un store terrasse.

L'activation de capteurs correspondant à deux zones sensitives non adjacentes au cours d'une séquence prédéfinie, pour provoquer la sélection d'un groupe d'équipements donné, permet de bien marquer la volonté de l'utilisateur et d'éviter les activations intempestives, en particulier dans le cadre de petites surfaces d'actionnement.

Selon des aspects avantageux mais non obligatoires de l'invention, un tel procédé peut incorporer une ou plusieurs des caractéristiques suivantes prises dans toute combinaison techniquement admissible :
- Un microcontrôleur reçoit un signal d'entrée fourni par chaque capteur capacitif lors de son activation, alors que ce microcontrôleur génère un premier signal de sortie correspondant à la sélection d'un groupe d'équipements associé à une zone sensitive en fonction du signal d'entrée fourni par un capteur capacitif correspondant à cette zone sensitive et que, suite à la mise en oeuvre de la séquence prédéterminée d'activations des capteurs capacitifs, le microcontrôleur génère un deuxième signal de sortie différent du premier signal. Le second signal généré lors de la réalisation complète de la séquence d'activation peut être utilisé pour différents objectifs. II peut permettre à l'utilisateur de disposer d'un signal supplémentaire, lui permettant de commander plus d'équipements individuellement ou simultanément. En particulier lorsque le deuxième signal généré permet de commander l'ensemble des équipements, il peut permettre également de sélectionner facilement quels équipements sont à commander.
- Lors d'une séquence prédéterminée d'activations successives de capteurs capacitifs, le microcontrôleur enregistre les signaux d'entrée fournis par les capteurs capacitifs, compare les signaux enregistrés avec des signaux, stockés en mémoire et correspondant à la séquence prédéterminée d'activations, et génère le deuxième signal en fonction du résultat de cette comparaison.
- La séquence prédéterminée d'activations comprend l'activation successive d'au moins trois capteurs capacitifs. Lorsqu'au moins trois capteurs doivent être activés, cela renforce l'assurance que la combinaison d'appuis n'est pas fortuite.
- La séquence prédéterminée d'activations comprend une étape finale dans laquelle un capteur capacitif est activé pendant une durée supérieure à une valeur prédéterminée. Au cours de la séquence d'appuis, le contrôle de l'activation d'au mois un des capteurs pendant une durée supérieure à un seuil prédéterminé évite les réactions suite à des effleurements rapides de la surface du panneau. En particulier si l'interface de commande est celle d'une télécommande nomade, celle-ci est régulièrement manipulée et sa surface peut être facilement touchée involontairement. L'introduction d'un temps d'activation minimum du dernier capteur de la séquence permet également une confirmation de l'intention de l'utilisateur. Cette activation correspond également à un appui prolongé, c'est à dire que le doigt reste sur le dernier capteur en fin de séquence. Cette activation est donc à la fois très intuitive tout en étant particulièrement simple à réaliser. Elle permet de confirmer une séquence mise en oeuvre.
- La séquence prédéterminée d'activations est telle que le décalage temporel entre deux activations successives de capteurs capacitifs a une durée inférieure à une valeur prédéterminée.
- La séquence prédéterminée d'activations est réalisée par un utilisateur en faisant glisser son doigt le long d'un écran de l'organe de commande, en regard des capteurs capacitifs à activer. La séquence d'activation peut être réalisée par un glissement du doigt sur les différents capteurs. L'instauration d'un temps d'activation maximum par capteur au cours de cette séquence permet de bien différencier ce mouvement d'une activation individuelle de capteur.
- Chaque activation d'un capteur capacitif ou la mise en oeuvre de la séquence prédéterminée d'activations provoque l'émission d'un signal de retour d'information, visuel et/ou sonore, à destination de l'utilisateur. En particulier, une information visuelle et/ou sonore caractérise de manière spécifique la réalisation d'une séquence particulière, de sorte que l'utilisateur puisse bien se rendre compte de la manoeuvre qu'il a initiée. Ce retour d'information, peut être très simplement réalisé à l'aide d'une diode électroluminescente qui indique de façon très simple par son état allumé ou éteint si le capteur a été activé ou non. Avantageusement, ce même moyen peut être utilisé pour un retour d'information relatif à la réalisation de la séquence d'activation. Ainsi, aucun autre moyen de retour d'information n'est nécessaire, les moyens existants peuvent être réutilisés et combinés.
- Les premiers signaux de sortie correspondent à la sélection individuelle du groupe d'équipements associé à une zone sensitive, alors que le deuxième signal de sortie correspond à la sélection individuelle du groupe supplémentaire d'équipements.
- Le groupe supplémentaire est constitué de l'ensemble union des groupes d'équipements correspondant aux capteurs activés pendant la séquence prédéterminée d'activations.
- Lorsqu'une séquence prédéterminée d'activations a été effectuée, l'activation individuelle d'un capteur capacitif provoque l'exclusion du groupe d'équipements correspondant hors du groupe supplémentaire ou son introduction dans ce groupe, selon qu'il faisait déjà partie de ce groupe ou non.

Le procédé peut être utilisé pour constituer de manière très simple un groupe ad-hoc, par sélection de l'ensemble des équipements dans le groupe supplémentaire, puis élimination d'un ou plusieurs équipements indésirables.

Le procédé est avantageusement utilisé dans le cadre d'une interface de commande, en particulier pour un interrupteur mural destiné à la commande d'équipements domotiques. Ainsi, l'utilisateur dispose d'un interrupteur montrant des caractéristiques technologiques tout en restant particulièrement simple à utiliser et assurant l'impression sensorielle que l'utilisateur souhaite.

L'invention concerne également un organe permettant de mettre en oeuvre le procédé mentionné ci-dessus et, plus spécifiquement, un organe de commande d'une installation comprenant plusieurs groupes d'équipements domotiques prédéfinis, cet organe comprenant au moins une zone sensitive de sélection d'un groupe d'équipements **caractérisé en ce que** l'organe de commande comprend plusieurs zones de sélection disposées côte à côte, en ce que chaque zone de sélection est associée à un capteur capacitif et, en ce qu'un microcontrôleur faisant partie de l'organe de commande est apte à traiter des signaux d'entrée fournis par les capteurs capacitifs et à émettre des signaux de sortie qui sont en nombre strictement supérieur au nombre de zones de sélection et qui dépendent des signaux fournis par les capteurs capacitifs.

De façon avantageuse mais non obligatoire, un tel organe peut incorporer une ou plusieurs des caractéristiques suivantes, prises dans toute combinaison techniquement admissible :
- Une diode électroluminescente est associée à chaque capteur capacitif au sein d'une zone sensitive de sélection, la diode étant apte à être allumée lorsque le capteur est activé.
- L'organe comprend un écran recouvrant au moins les capteurs capacitifs et les diodes associées, l'écran étant translucide ou transparent, à la fréquence de la lumière émise par les diodes, au moins dans sa partie qui recouvre les diodes, alors que l'écran est pourvu, en regard de chaque capteur capacitif, d'un relief permettant un repérage au toucher des différentes zones sensitives de sélection. Par exemple, le fait que chaque capteur soit repéré par une légère surépaisseur sur une surface lisse permet de bien distinguer les appuis sans pour autant empêcher un glissement du doigt sur la surface.
- L'organe comprend, en plus des zones sensitives de sélection, des moyens de commande d'un groupe d'équipements sélectionné.

L'invention sera mieux comprise et d'autres avantages de celles-ci apparaîtront plus clairement à la lumière de la description qui va suivre d'une installation incorporant un organe de commande conforme à l'invention et de procédés de sélection conformes à son principe, donnés uniquement à titre d'exemple et faisant référence aux dessins annexés dans lesquels :
- la figure 1 est une représentation schématique de principe d'une installation domotique incorporant un organe conforme à l'invention ;
- la figure 2 est une coupe partielle de principe selon la ligne II-II à la figure 1 ;
- la figure 3 est une vue de face de l'organe de commande de l'installation de la figure 1 dont l'écran et le plastron sont omis pour la clarté du dessin et

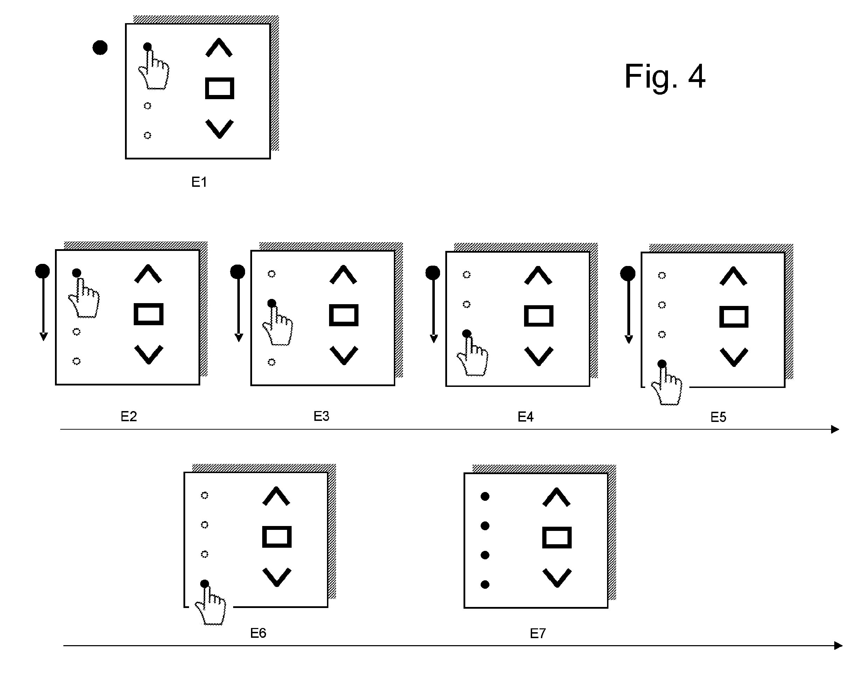

- la figure 4 est un schéma explicatif de la mise en oeuvre d'un procédé de sélection conforme à l'invention.

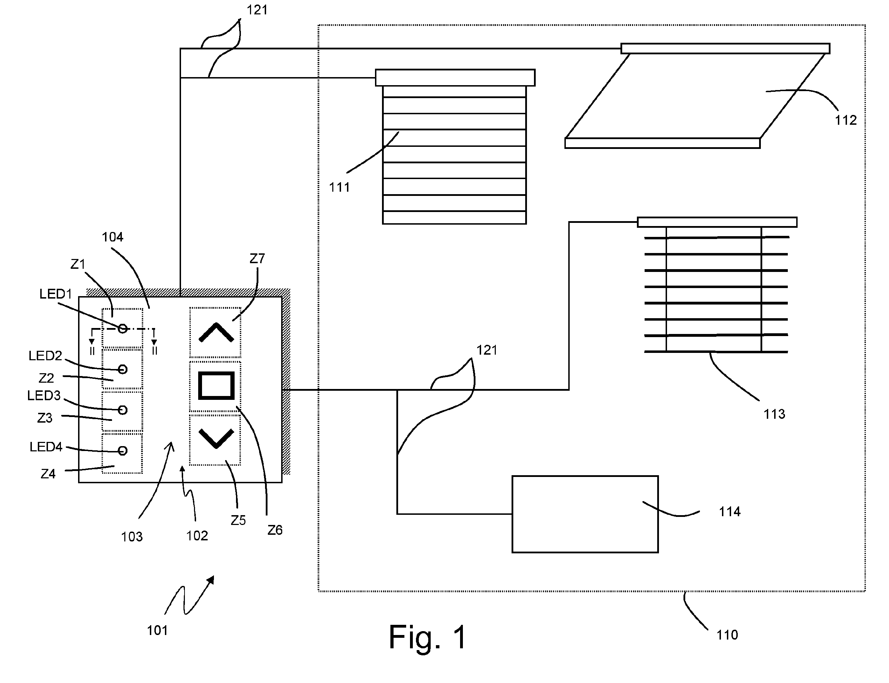

La figure 1 montre une installation domotique 101 comprenant d'une part un point de commande 102 mural destiné à la commande d'appareils électromécaniques ou électriques de la maison. Pour cela, le point de commande 102 est relié par des câbles 121 à ces appareils. Selon une variante non représentée de l'invention, le point de commande 102 est relié aux appareils par voie non filaire, par exemple par radio.

L'ensemble des appareils est référencé 110. II comprend notamment un volet roulant motorisé 111, un store de terrasse motorisé 112, un store vénitien motorisé 113 et un autre appareil 114 pouvant être du même type que les précédents ou d'un autre type, y compris un appareil de chauffage, de climatisation, une lampe, etc. Chaque élément de l'installation 101 comprend des moyens non représentés pour son alimentation, soit propre soit par connexion sur un réseau.

Le point de commande 102 est formé par un panneau capacitif muni d'une interface homme-machine 103, cette interface comprenant sur un écran 104 une pluralité de zones d'activation sensitives Z1-Z7 de type capacitif, équivalentes à des touches, et symbolisées par des carrés en pointillés à la figure 1. Ces zones sensitives forment des touches sensitives et sont respectivement associées chacune à un capteur capacitif C1 à C7 et certaines de ces zones dites zones de sélection, à savoir les zones Z1 à Z4, sont également chacune associées à une diode électroluminescente respectivement LED1 à LED4. L'écran 104 forme un couvercle en-dessous duquel sont placés, sur un circuit imprimé 105, les capteurs C1-C7, les diodes LED1 à LED4 et un microcontrôleur 106 capable d'analyser des signaux d'entrée S1 à S7 fournis par les capteurs C1 à C7 lorsqu'ils sont activés et de produire des signaux de sortie S'1 à S'N en fonction des signaux fournis par ces capteurs, où N est un nombre entier strictement supérieur à 4, c'est-à-dire le nombre de zones de sélection).

Dans chaque partie disposée en regard d'une diode LED1 à LED4, l'écran 104 est transparent ou, à tout le moins translucide, ce qui permet à un utilisateur de percevoir l'éclairage d'une diode à travers l'écran 104.

Au sens de la présente invention, un capteur C1-C7 est activé lorsque, du fait de la modification de sa capacité résultant de l'appui ou du passage d'un doigt d'un utilisateur à proximité de ce capteur, les propriétés physiques de ce capteur sont modifiées au-delà d'un certain seuil. Une fois activé, le capteur fournit un signal d'entrée S1, S2, S3 ou S4 au microcontrôleur 106.

Les zones de sélection Z1 à Z4 associées aux diodes LED1 à LED4 permettent la sélection de canal de transmission de données, tandis que les autres zones Z5 à Z7 sont des touches de commande d'un appareil de l'ensemble 10. Ainsi, la zone Z5 permet de commander les appareils 111 à 113 à la fermeture ou une lampe formant l'appareil 114 à la baisse de son intensité lumineuse, alors que la touche Z7 permet de commander ces appareils à l'ouverture ou à la hausse de l'intensité lumineuse et que la zone Z6 est une zone de commande d'arrêt ou d'interruption de fonctionnement. Dans le cas d'un éclairage, la touche Z6 peut être utilisée pour passer alternativement d'un état allumé à un état éteint.

Le point de commande 102 est capable d'émettre des signaux sur plusieurs canaux. Au sens de la présente invention, un canal correspond à la sélection logique d'un équipement ou d'un groupe d'équipements dans l'ensemble 110, cette sélection étant, en pratique, effectuée par un adressage spécifique incorporé à un signal électromagnétique transmis via les câbles 121 ou par ondes radio sur une fréquence porteuse commune à l'ensemble des équipements. Alternativement, un canal peut être défini par une fréquence porteuse propre à ce canal.

Chaque canal permet de transmettre des ordres de commande à un ou plusieurs appareil(s) sélectionné(s) selon la configuration de l'installation domotique. Le canal 1 peut ainsi permettre de commander le volet roulant 111, alors que le canal 2 commande le store de terrasse 112, le canal 3 commande les stores d'intérieur 113 et le canal 4 commande la lampe principale 114 de la pièce dans laquelle est installé le point de commande 102.

Un plastron 107 est placé entre le circuit imprimé 105 et le couvercle 104, de manière à masquer les composants électroniques, sans pour autant perturber le fonctionnement des capteurs capacitifs C1 à C7. Dans cet exemple, la zone d'activation de chaque capteur C1 à C4 est centrée autour d'une diode et le couvercle 104 comprend sur sa surface supérieure une zone sensorielle ZS matérialisée ici par une légère surépaisseur 108 détectable au toucher. Alternativement, cette zone sensorielle ZS pourrait être constituée par un creux ou toute autre relief permettant de la détecter au toucher.

La surépaisseur 108 peut également servir de loupe permettant de mieux transmettre l'éclairage d'une diode à travers l'écran 104 qui est transparent ou translucide, au moins dans cette zone.

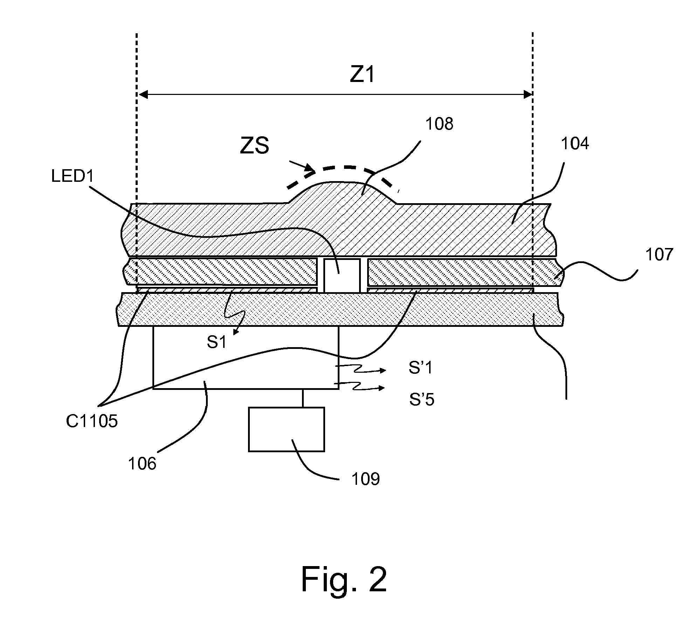

En prenant exemple sur la figure 2, lorsque le capteur C1 est activé, il fournit au microcontrôleur 106 un signal d'entrée S1 traduisant son état d'activation. Cet état d'activation correspond à la sélection du volet roulant 111 souhaitée par l'utilisateur. Ainsi, lorsque l'une des zones Z5 à Z7 est activée postérieurement à la sélection du volet 111, un signal de sortie S'1 est incorporé à l'ordre de commande adressé à l'ensemble d'appareils 110 par le point de commande 102. De la même manière, lorsque l'un des capteurs C2 à C4 est activé, il fournit au microcontrôleur 106 un signal d'entrée correspondant S2 à S4 et celui-ci incorpore aux signaux de commande destinés aux appareils de l'ensemble 110 des signaux de sortie correspondants S'2 à S'4.

Le signal d'entrée S1, S2, S3, S4 fourni par un capteur C1 à C4 activé ou le signal de sortie correspondant S'1 à S'4, émis par le microcontrôleur 106 en réponse au signal d'entrée S1, S2, S3 ou S4, permet également de provoquer l'allumage de la diode LED1 à LED4 correspondant au capteur activé. II permet également d'éteindre les diodes correspondant aux capteurs non activés. L'utilisateur perçoit cet éclairement de la diode comme un signal de retour d'information lui confirmant que le capteur en question est bien activé.

En variante ou additionnellement, le signal de retour d'information peut être sonore.

L'invention permet, selon un premier mode de réalisation, de sélectionner un canal indépendant supplémentaire, par rapport aux canaux 1 à 4, à l'aide des zones d'activation Z1 à Z4.

Différents exemples montrent qu'il est possible de sélectionner d'autres canaux indépendants supplémentaires, sur la base de différentes séquences d'activation des quatre capteurs associés aux zones Z1 à Z4. Ces exemples sont repris dans le tableau ci-dessous, sous la forme d'une liste non exhaustive :

| N ° de canal | Séquence |
|---|---|
| 1 | Z1 |
| 2 | Z2 |
| 3 | Z3 |
| 4 | Z4 |
| 5 | Z1-Z2-Z3-Z4 |
| 6 | Z4-Z3-Z2-Z1 |
| 7 | Z1-Z2-Z3 |
| 8 | Z2-Z3-Z4 |
| 9 | Z3-Z2-Z1 |
| 10 | Z4-Z3-Z2 |

Dans cet exemple, le nombre N mentionné ci-dessus est égal à 10. Dans ce tableau, les canaux 5 à 10 représentent des configurations obtenues par un simple glissement du doigt.

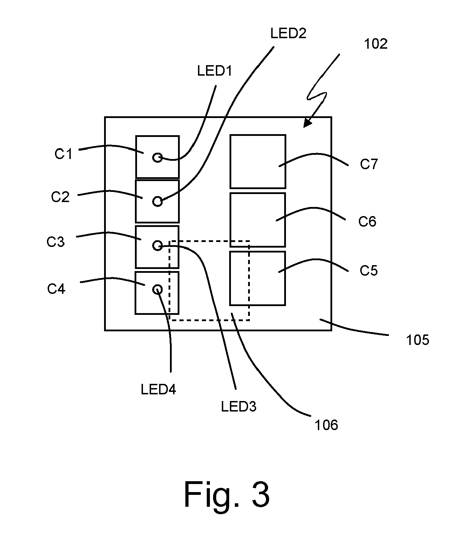

Certains de ces exemples sont plus intuitifs que d'autres. L'exemple de sélection du canal numéroté 5 est décrit en référence à la figure 3.

Au cours d'une étape E1, lorsqu'un seul des capteurs C1 à C4 est activé, par exemple celui correspondant au canal 1, la diode LED1 correspondante s'allume et un ordre de commande passé à ce moment là, en appuyant sur une des zones Z5 à Z7, est émis vers le ou les appareils associés au canal 1, le volet roulant 111 dans l'exemple mentionné ci-dessus. La configuration représentée à l'étape E1 peut également correspondre à une situation par défaut. Cependant, pour des questions d'économie d'énergie, les diodes, et en particulier la première diode LED1, ne restent normalement pas allumées en permanence. La première diode LED1 peut se rallumer lors d'une prochaine commande, sans qu'il soit nécessaire d'activer de nouveau la zone correspondant au capteur C1 si celui-ci est relatif au canal par défaut.

Lors de cette étape E1, lorsque l'utilisateur pose son doigt sur la zone Z1, il active le capteur C1 correspondant et celui-ci fournit au microcontrôleur 106 un signal d'entrée S1 qui permet au microcontrôleur d'émettre un signal de sortie S'1 correspondant à la sélection du premier canal, et donc du premier groupe d'appareils, à savoir le volet 111. Ainsi, on sélectionne le groupe du volet roulant 111 en activant le capteur C1.

Cette approche de l'étape E1 est utilisée à chaque fois que l'on souhaite commander l'un des appareils 111 à 114, sur l'un des canaux 1 à 4, le microcontrôleur 106 émettant alors un signal de sortie S'1 à S'4 en fonction du ou des appareils sélectionnés.

On décrit maintenant la démarche à suivre pour émettre un signal sur le canal 5.

Au cours d'une étape E2, l'utilisateur place son doigt sur la zone Z1 correspondant au capteur C1. La diode LED1 s'allume. Au cours d'une étape E3, l'utilisateur place son doigt sur la zone Z2 correspondant au capteur C2. La première diode LED1 s'éteint alors et la deuxième diode LED2 s'allume.

De façon similaire, lorsque l'utilisateur déplace ensuite relativement rapidement, c'est-à-dire en moins de 200 ms, son doigt vers la zone Z3 du capteur C3 à l'étape E4, la deuxième diode LED2 s'éteint alors et la troisième diode LED3 s'allume. Puis, lorsque l'utilisateur déplace relativement rapidement son doigt à l'étape E5, vers la zone Z4 du capteur C4, la troisième diode LED3 s'éteint alors et la quatrième diode LED4 s'allume.

Au cours d'une étape subséquente E6, l'utilisateur maintient son doigt sur la zone Z4 correspondant au capteur C4 pendant un intervalle de temps de durée supérieure à une valeur Δt₁ prédéterminée, par exemple égale à 1 seconde, préférentiellement à 500 ms.

En variante, l'étape E6 décrite ci-dessus peut être remplacée par un autre mécanisme de confirmation, comme un appui rapide sur la dernière touche effleurée.

Pour valider la séquence prédéterminée Z1-Z2-Z3-Z' d'activations des capteurs C1-C4, le microcontrôleur 106 vérifie que le décalage temporel entre deux activations successives des capteurs, c'est-à-dire entre deux des étapes E2 à E5, est inférieur à une valeur de seuil prédéterminée Δt₂, par exemple égale à 200 ms.

Le microcontrôleur vérifie également ou alternativement que l'ensemble des étapes E2 à E6 se déroule dans une période de temps ΔT prédéfinie, ΔT étant par exemple égale à 2 secondes.

Si le microcontrôleur établit que le décalage temporel entre deux étapes E2 à E5 est inférieur à Δt₂, et/ou que la durée totale des étapes E2 à E6 est inférieure à ΔT et que l'activation du capteur C4 à l'étape E6 est maintenue pendant une durée suffisante, supérieure à Δt₁, les conditions de réalisation de la séquence prédéterminée d'activations des capteurs C1 à C4 correspondant au canal 5 sont considérées par le microcontrôleur 106 comme remplies. La totalité des diodes LED1-LED4 s'allume alors dans une étape subséquente E7. En effet, le microcontrôleur 106 détermine qu'il a reçu, dans les conditions de temps et d'ordre, les différents signaux d'entrée issus des capteurs C1-C4 conformément à une séquence prédéfinie et il génère alors un deuxième signal de sortie S'5, permettant, d'une part, l'allumage simultané des différentes diodes LED1 à LED4 et, d'autre part, la sélection des appareils correspondant au canal 5. Les commandes passées à l'aide des capteurs C5-C7 concernent alors les appareils désignés pour le canal 5, par exemple la totalité des appareils reliés au point de commande 102.

L'allumage simultané des diodes LED1 à LED4 à l'étape E7 constitue un signal de retour d'information pour l'utilisateur qui lui permet de s'assurer que la séquence prédéterminée d'activation des capteurs C1 à C4 qu'il vient de réaliser lui a effectivement permis d'émettre sur le canal 5.

Lorsque l'utilisateur exécute la séquence prédéterminée Z1-Z2-Z3-Z4 d'activations des capteurs C1 à C4, le microcontrôleur 106 enregistre les signaux d'entrée S1 à S4 successivement fournis par les capteurs C1 à C4 et les délais entre ces signaux et les compare à des données relatives à des signaux stockées dans une mémoire 109 montée sur le circuit 105. Le microcontrôleur 106 est donc à même de comparer l'enchaînement des signaux d'entrée qu'il reçoit des capteurs C1 à C4 avec une séquence prédéterminée correspondant aux valeurs stockées dans la mémoire 109. Si l'enchaînement des signaux correspond effectivement à cette séquence, le microcontrôleur 106 génère le deuxième signal S'5. Dans le cas contraire, le microcontrôleur ne génère pas le signal S'5.

Le deuxième signal S'5 n'est généré que lorsque la séquence d'activation Z1-Z2-Z3-Z4 est complète, ce qui évite de nouveau les activations intempestives.

Le groupe supplémentaire d'équipements correspondant au deuxième signal S'5 peut être formé par des équipements totalement différents de ceux correspondant aux quatre premiers groupes d'équipement. Inversement, le groupe supplémentaire peut être formé par l'ensemble union de plusieurs groupes d'équipements, voire de la totalité des quatre groupes d'équipements.

Dans cet exemple, lors de l'activation individuelle d'un capteur C1 à C4, le signal généré précédemment est annulé. En effet, lorsque le doigt glisse d'une première zone d'activation, par exemple Z1, vers une nouvelle zone d'activation, par exemple Z2, la première diode LED1 s'éteint et la deuxième diode LED2 correspondant à la deuxième zone d'activation s'allume. Ainsi, si une séquence d'activation Z1-Z2-Z3-Z4 est interrompue en cours de réalisation, ou si celle-ci n'est pas confirmée par une activation prolongée du dernier capteur à l'étape E6, le dernier canal simple activé reste actif.

Dans la mesure où chaque activation individuelle annule l'activation précédente, la séquence d'activation peut être interrompue en cours sans que cela ne porte à conséquence. Le dernier des signaux générés est le signal pris en compte, sans obliger l'utilisateur à renouveler son activation.

L'invention permet, selon un deuxième mode de réalisation, de fournir un deuxième signal ayant pour effet de modifier la gestion des signaux issus des capteurs par le microcontrôleur.

Dans un cas d'utilisation préférée, le groupe supplémentaire d'équipements est formé par l'ensemble union de tous les groupes d'équipements. Une fois ce groupe supplémentaire sélectionné par la séquence d'activation Z1-Z2-Z3-Z4, une nouvelle activation d'un capteur C1 à C4 provoque dans ce cas non pas un nouveau premier signal, mais l'exclusion du capteur activé du groupe supplémentaire ou son introduction dans le groupe s'il n'en fait pas ou plus partie. II est alors possible de sélectionner simultanément et sélectivement plusieurs zones Z1 à Z4 sans nécessairement réaliser des appuis simultanés au niveau de ces zones. Ce mode particulier de fonctionnement reste valable pendant une période prédéterminée après la réalisation de la séquence d'activation. Ainsi la constitution d'un groupe supplémentaire ad-hoc est réalisée de manière simple.

L'invention permet, selon un troisième mode de réalisation dépendant des deux premiers, de générer un signal permettant un retour d'information préalable vers l'utilisateur.

Ce troisième mode de réalisation repose sur l'analyse dynamique des informations fournies par les capteurs C1 à C4.

Lorsqu'un utilisateur approche son doigt du panneau capacitif 102, il est possible de détecter cet effet au travers d'une variation du signal fourni par un ou plusieurs capteurs C1 à C4. En variante, cette détection d'approche peut être effectuée au moyen d'un autre capteur qui n'est pas forcément capacitif mais, par exemple, de type infrarouge. Dans tous les cas, cela permet de détecter l'approche du doigt d'un utilisateur avant l'activation effective d'un ou plusieurs des capteurs C1 à C4.

Lorsqu'un ou plusieurs capteurs C1 à C4 viennent à émettre un signal de faible intensité d'activation, le microcontrôleur 106 en déduit l'approche du doigt d'un utilisateur et génère un signal d'approche. Ce signal d'approche permet de générer un allumage des diodes dans une première couleur ou avec une intensité plus faible que l'éclairage standard. L'allumage peut concerner l'ensemble des diodes disponibles ou uniquement celles correspondant aux capteurs ayant fourni un premier signal de faible intensité au microcontrôleur. Alternativement, l'allumage peut concerner le canal actif par défaut. L'utilisateur dispose ainsi d'une première information visuelle avant de venir activer le capteur choisi.

Pour mettre en oeuvre la séquence prédéterminée d'activations Z1-Z2-Z3-Z4 sur un interrupteur mural du type du panneau capacitif 102, l'utilisateur approche et pose son doigt sur la première zone Z1 et la diode correspondant au premier capteur C1 s'allume alors dans un premier temps dans sa première couleur, ou à faible intensité, puis dans une deuxième couleur, ou avec son intensité standard. Les autres zones Z2 à Z4 étant légèrement couvertes par le doigt, les capteurs correspondants détectent alors encore la proximité d'un doigt, en particulier la zone adjacente Z2. La ou les diodes correspondantes sont allumées dans leur première couleur ou avec une faible intensité. Lorsque l'utilisateur fait glisser son doigt le long du panneau capacitif 102 le long des zones d'activations Z1-Z4, les diodes des zones proches du doigt s'allument séquentiellement selon leur éclairage standard, tandis que les premières diodes s'éteignent complètement, fournissent une intensité plus faible ou une première couleur. La modification d'éclairage des diodes donne l'impression visuelle d'indiquer le chemin à suivre par le doigt.

L'interface homme-machine présentée 103 peut comprendre des capteurs capacitifs C1 à C4 pour la sélection du canal de commande et des touches mécaniques, à la place des capteurs C5 à C7, pour les touches de commande, sans que cela ne sorte du cadre de l'invention.

L'utilisation des capteurs capacitifs C1 à C4 combinés avec les diodes LED1 à LED4 permet d'accroître la perception sensorielle de l'utilisateur, de même que la mise en oeuvre de légères surépaisseurs au niveau des zones de capteurs. Ces surépaisseurs ne gênent en rien un glissement du doigt sur l'écran 104, mais constituent des zones sensorielles Z5 qui permettent à un utilisateur de bien percevoir la réalisation d'une séquence d'activation. La technologie capacitive est en effet souvent critiquée pour l'absence de retour sensoriel. L'invention permet ainsi de remédier à ce problème souvent évoqué, en introduisant une information sensorielle, que ce soit au niveau d'une simple activation ou d'une activation plus complexe, mais intuitive, d'un ensemble de capteurs.

En variante, les diodes LED sont décalées par rapport aux zones de capteurs.

L'invention laisse enfin possible l'activation simultanée de deux capteurs C1 à C4 pour la génération d'un troisième signal, également utilisable pour accroître le nombre de groupes ou pour entrer dans des séquences particulières de programmation.

L'invention est expliquée ci-dessus en référence au cas où un deuxième signal de sortie S'5 émis par le microcontrôleur 106 correspond au canal 5. de la même manière, en fonctions de sa programmation, des signaux S'6 à S'10 peuvent être émis par le microcontrôleur 106, en correspondance avec les canaux 6 à 10 du tableau ci-dessus.

## Revendications

1. Procédé de sélection d'un groupe d'équipements domotiques (111-114) à commander parmi plusieurs groupes d'équipements prédéfinis, au moyen de zones sensitives (Z1, Z2, Z3, Z4) d'un organe de commande (102), ces zones sensitives correspondant chacune à un capteur capacitif (C1, C2, C3, C4) et étant disposées côte à côte au niveau de l'organe de commande, le procédé de sélection étant tel que :
- on sélectionne un groupe d'équipements prédéfini associé à une zone sensitive donnée (Z1, Z2, Z3, Z4) en activant le capteur capacitif (C1, C2, C3, C4) correspondant à cette zone sensitive ; et
- on sélectionne au moins un groupe supplémentaire d'équipements, différent de ceux correspondant à chaque zone sensitive, au moyen d'une séquence prédéterminée (Z1-Z2-Z3-Z4) d'activations de plusieurs capteurs capacitifs (C1-C4), dont au moins deux capteurs capacitifs correspondant à deux zones sensitives non adjacentes.

2. Procédé selon la revendication 1 **caractérisé en ce qu'**un microcontrôleur (106) reçoit un signal d'entrée (S1-S4) fourni par chaque capteur capacitif (C1-C4) lors de son activation, **en ce que** ce microcontrôleur génère un premier signal de sortie (S'1-S'4) correspondant à la sélection d'un groupe d'équipements associé à une zone sensitive (Z1, Z2, Z3, Z4) en fonction du signal d'entrée fourni par un capteur capacitif correspondant à cette zone sensitive et **en ce que**, suite à la mise en oeuvre de la séquence prédéterminée (Z1-Z2-Z3-Z4) d'activations des capteurs capacitifs, le microcontrôleur génère un deuxième signal de sortie (S'5) différent du premier signal.

3. Procédé selon la revendication 2 **caractérisé en ce que**, lors d'une séquence prédéterminée (Z1-Z2-Z3-Z4) d'activations successives de capteurs capacitifs (C1-C4), le microcontrôleur (106) enregistre les signaux d'entrée (S1-S4) fournis par les capteurs capacitifs, compare les signaux enregistrés avec des signaux, stockés en mémoire (109) et correspondant à la séquence prédéterminée d'activations, et génère le deuxième signal (S'5) en fonction du résultat de cette comparaison.

4. Procédé selon l'une des revendications précédentes **caractérisé en ce que** la séquence prédéterminée d'activations (Z1-Z2-Z3-Z4) comprend l'activation successive d'au moins trois capteurs capacitifs (C1-C4).

5. Procédé selon l'une des revendications précédentes **caractérisé en ce que** la séquence prédéterminée (Z1-Z2-Z3-Z4) d'activations comprend une étape finale (E6) dans laquelle un capteur capacitif (C4) est activé pendant une durée supérieure à une valeur prédéterminée (Δt₁).

6. Procédé selon l'une des revendications précédentes **caractérisé en ce que** la séquence prédéterminée (Z1-Z2-Z3-Z4) d'activations est telle que le décalage temporel entre deux activations successives de capteurs capacitifs (C1-C4) a une durée inférieure à une valeur prédéterminée (Δt₂).

7. Procédé selon l'une des revendications précédentes **caractérisé en ce que** la séquence prédéterminée (Z1-Z2-Z3-Z4) d'activations est réalisée par un utilisateur en faisant glisser son doigt le long d'un écran (104) de l'organe de commande (102), en regard des capteurs capacitifs (C1-C4) à activer.

8. Procédé selon l'une des revendications précédentes **caractérisé en ce que** chaque activation d'un capteur capacitif (C1-C4) ou la mise en oeuvre de la séquence prédéterminée (Z1-Z2-Z3-Z4) d'activations provoque l'émission d'un signal de retour d'information, visuel et/ou sonore, à destination de l'utilisateur.

9. Procédé selon l'une des revendications précédentes **caractérisé en ce que** les premiers signaux de sortie (S'1-S'4) correspondent à la sélection individuelle du groupe d'équipements (111-114) associé à une zone sensitive (Z1, Z2, Z3, Z4) et **en ce que** le deuxième signal de sortie (S'5) correspond à la sélection individuelle du groupe supplémentaire d'équipements.

10. Procédé selon l'une des revendications 1 à 9 **caractérisé en ce que** le groupe supplémentaire est constitué de l'ensemble union des groupes d'équipements (111-114) correspondant aux capteurs (C1-C4) activés pendant la séquence prédéterminée (Z1-Z2-Z3-Z4) d'activations.

11. Procédé selon la revendication 10 **caractérisé en ce que**, lorsqu'une séquence prédéterminée (Z1-Z2-Z3-Z4) d'activations a été effectuée, l'activation individuelle d'un capteur capacitif (C1-C4) provoque l'exclusion du groupe d'équipements correspondant hors du groupe supplémentaire ou son introduction dans ce groupe, selon qu'il faisait déjà partie de ce groupe ou non.

12. Organe de commande (102) d'une installation comprenant plusieurs groupes d'équipements domotiques (111-114) prédéfinis, cet organe comprenant au moins une zone (Z1, Z2, Z3, Z4) sensitive de sélection d'un groupe d'équipements **caractérisé en ce que** l'organe de commande (102) comprend plusieurs zones de sélection (Z1, Z2, Z3, Z4) disposées côte à côte, **en ce que** chaque zone de sélection est associée à un capteur capacitif (C1-C4) et **en ce qu'**un microcontrôleur (106) faisant partie de l'organe de commande est apte à traiter des signaux d'entrée (S1-S4) fournis par les capteurs capacitifs et à émettre des signaux de sortie (S'1-S'5) qui sont en nombre (N) strictement supérieur au nombre de zones de sélection et qui dépendent des signaux fournis par les capteurs capacitifs.

13. Organe de commande selon la revendication 12 **caractérisé en ce qu'**une diode électroluminescente (LED1-LED4) est associée à chaque capteur capacitif (C1-C4) au sein d'une zone sensitive de sélection (Z1-Z4), la diode étant apte à être allumée lorsque le capteur est activé.

14. Organe de commande selon la revendication 13 **caractérisé en ce qu'**il comprend un écran (104) recouvrant au moins les capteurs capacitifs (C1-C4) et les diodes associées (LED1-LED4), l'écran étant translucide ou transparent, à la fréquence de la lumière émise par les diodes, au moins dans sa partie qui recouvre les diodes et **en ce que** l'écran (104) est pourvu, en regard de chaque capteur capacitif (C1-C4), d'un relief (108) permettant un repérage au toucher des différentes zones sensitives de sélection (Z1-Z4).

15. Organe de commande selon l'une des revendications 12 à 14 **caractérisé en ce qu'**il comprend, en plus des zones sensitives de sélection (Z1-Z4), des moyens de commande (C5-C7) d'un groupe d'équipements (111-114) sélectionné.
